Europäisches Patentamt

European Patent Office

Office européen des brevets

(19)

(11) **EP 1 513 254 A1**

(12) **EUROPEAN PATENT APPLICATION**

(43) Date of publication:
**09.03.2005 Bulletin 2005/10**

(51) Int Cl.⁷: **H03H 17/06**

(21) Application number: **03292099.3**

(22) Date of filing: **26.08.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicants:
• **Mitsubishi Electric Information Technology
Centre Europe B.V.
35700 Rennes (FR)**

• **MITSUBISHI DENKI KABUSHIKI KAISHA
Tokyo 100-8310 (JP)**

(72) Inventor: **Bisiaux, Alexis
35700 Rennes (FR)**

(74) Representative: **Blot, Philippe Robert Emile et al
Cabinet Lavoix
2, place d'Estienne d'Orves
75441 Paris Cedex 09 (FR)**

(54) **Filter enabling decimation of digital signals by a rational factor**

(57)     The invention concerns a decimation filter for decimation of a digital signal by a rational decimation factor ($R$) including :

- a cascade of integrators (12),
- at least a comb branch (16A, 16B) including

  - a decimator (18A, 18B),
  - a cascade of differentiators (22A, 22B),

  It includes :

- a first and a second comb branches (16A, 16B) both adapted to receive the samples from said cascade of integrators (12), the decimators (18A, 18B) of the first and second comb branches having a first and a second integer decimation factors ($R_1$, $R_2$) which are different,
- switching means (26, 28) for delivering at the output of the filter successively a first set of consecutive samples outputted by the first comb branch (16A) and a second set of consecutive samples outputted by the second comb branch (16B).

Application to a software defined radio system.

FIG.1

**Description**

The present invention concerns a filter enabling decimation of digital signals by a rational factor including :

- a cascade of integrators,
- at least a comb branch including

  - a decimator,
  - a cascade of differentiators.

Software Defined Radio systems (SDR or SWR) are meant to accommodate for a large variety of signals, modulations and bandwidths. Typically, an SDR receiver would use a wide-band Analogue to Digital Converter (ADC) running at a high sampling rate, and further decimate the signal and keep only the required bandwidth depending on the application. The decimation ratio ($R$) between the constant sampling frequency of the ADC ($F_s$) and the last processing rate of the signal ($F_s/R$) depends on the modulation type. It can be very large and may also be rational.

A large decimation ratio can be obtained by using a Cascaded Integrator Comb filter (CIC filter).

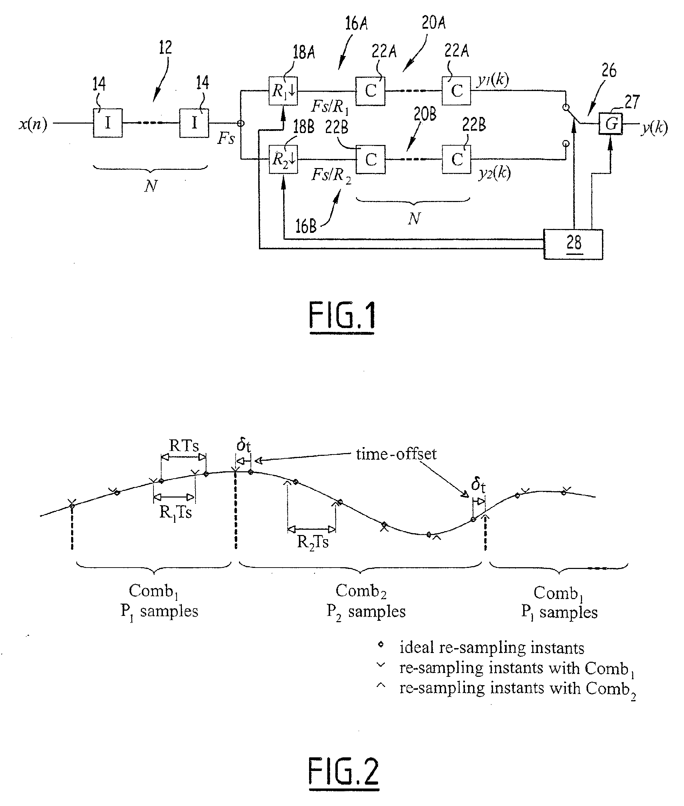

A decimation CIC filter is composed of a cascade of $N$ integrators working at the highest rate $F_s$, a decimator that keeps only one sample out of $R$, and $N$ comb stages, or differentiators, working at the lowest rate $F_s/R$, as shown in figure 1. A last parameter $M$, the differential delay, can be used to shape the filter's frequency response. $M$ is usually chosen to be 1 or 2.

In a CIC filter, $R$ is restricted to be an integer. In many applications though, the decimation rate should be rational. Several architectures consisting in modified CIC filters have been previously proposed to implement a rational decimation rate.

Three approaches exist for decimation systems with rational factors.

The first one consists in cascading 2 CIC filters, one operates as an interpolator which increases the rate by a factor $R_1$. The other one acts as a decimator which reduces the rate by a factor $R_2$. The new sample rate is then $R_1/R_2$ times the input sample rate. Since the intermediate rate is much too high to be actually worked out, additional logic must be provided to have the interpolator compute only the intermediate sample that the decimator really needs. Such a method has been described by M. Henker, T. Hentschel, G. Fettweis in "Time-variant CIC-filters for sample rate conversion with arbitrary rational factors", in 6th International Conference on Electronics, Circuits and Systems (ICECS'99), Paphos, Cyprus. IEEE. It requires 2 CIC filters plus additional complex control logic, which is very demanding in terms of hardware resources and power consumption.

A second approach involves a single decimation CIC filter in which an interpolator is introduced between the last integrator stage and the decimator. The interpolator may be realised with a linear filter as disclosed by D. Babic, J. Vesma, M. Renors in "Decimation by irrational factor using CIC filter and linear interpolation", in International Conference on Acoustics, Speech, and Signal Processing (ICASSP 2001), Salt Lake City, USA or with polynomials as disclosed by D. Babic, M. Renfors, "Programmable modified fractional comb decimation filter", in 11th European Signal Processing Conference (EUSIPCO 2002), Toulouse, France. Both imply an increase in hardware resources.

The last approach is often encountered in commercial Digital Down Converters (DDCs) like in Datasheets of commercial DDCs : HSP50216 (Intersil), GC4016 (Texas Instruments). Such devices generally feature a decimation CIC followed by a decimation FIR filter and finally a resampler. The resampler is actually a device that increases the rate by a constant factor with an interpolator and then keeps the sample that is the closest to the desired sampling instant. This method requires an additional FIR interpolator which highly increases complexity, and it introduces time-jitter that is inversely proportional to the interpolation factor.

The first two approaches tend to compute the value of the intermediate samples at the exact desired instants $k \times R/Fs$ ($k$ being an integer), but it comes at a high computational price. The third one involves an additional interpolator that also increases complexity and that introduces time-jitter.

Consequently, the known filters have a high complexity or introduce a high signal distortion.

The aim of the invention is to propose a filter enabling decimation of digital signals by a rational factor, which is simpler than the methods above and thus less power consuming while introducing a slight time-jitter that remains negligible for high decimation rates.

Accordingly, the subject of the invention is a filter enabling decimation of digital signals by a rational factor as defined in claim 1.

According to particular embodiments, the filter comprises the features of one or more sub-claims.

The invention will be better understood on reading the description which follows, given merely by way of example and while referring to the drawings in which :

- figure 1 is a schematical view of a 2-comb decimation CIC filter according to the invention ;

- figure 2 is a curve of the signal to be filtered explaining the implementation of the invention and showing the slight time jitter which is negligible ;
- figure 3 is a curve of the signal to be filtered explaining the way to ensure the signal continuity when switching from one comb to the other according to the invention ; and
- figure 4 is a schedule showing the offset between switching time from one comb to the other in order to deal with signal discontinuities, latency and pipeline issues.

The principle of the invention is to use a modified decimation CIC filter featuring two parallel comb branches instead of one.

A filter 10 according to the invention is shown on figure 1.

It includes, at the entrance, an integration stage 12 made of a cascade of $N$ integrators 14 working at a high rate $F_s$.

Two parallel comb branches 16A, 16B denoted comb 1 and comb 2 are connected at the output of the integration stage 12. Each comb branch includes a decimator 18A, 18B and a differentiation stage 20A, 20B made of $N$ differentiators 22A, 22B.

Decimator 18A has a decimation factor $R_1$ while decimator 18B has a decimation factor $R_2$, $R_1$ and $R_2$ are both integers. Decimator 18A or 18B keeps only one sample out of $R_1$ or $R_2$, respectively.

The $N$ differentiators 22A or 22B are working at the lowest rate $F_s/R_1$ or $F_s/R_2$, respectively.

Switching means 26 are arranged to selectively connect the output of either comb branch 16A or comb branch 16B at the output of the filter.

An amplifier 27, having a two different compensation gains $G_1$ and $G_2$, is inserted between the switching means 26 and the output of the filter.

The switching means 26 and the amplifier 27 are driven by a driving unit 28.

The driving unit 28 is adapted to drive the switching 26 such that the output signal $y(k)$ provided at the output of the filter is a composite signal constituted by switching from one comb branch to the other. Thus, the filter output signal is made of $P_1$ consecutive samples taken out of comb branch 16A, the $P_2$ other consecutive samples being taken out of comb branch 16B, and so on.

This filter has a mean decimation ratio R given by:

$$R = \frac{P_1 R_1 + P_2 R_2}{P_1 + P_2} \tag{1}$$

The four parameters $R_1$, $P_1$, $R_2$, $P_2$ are adequately chosen to obtain the desired rational decimation factor.

Advantageously, the computation of $R_1$, $P_1$, $R_2$, $P_2$ is carried out as described below.

Let $R$ be the desired rational decimation factor, $R_i$ its integer part and $R_f$ its fractional part, so that:

$$R = R_i + R_f \quad R_i \in \mathbb{N} \ , \quad 0 < R_f < 1 \tag{2}$$

According to a best mode of the invention, the choice of $R_1$ and $R_2$ should be made according to the following table:

Table 1

| $R_f$ | $R_1$ | $R_2$ | relation between $P_1/P_2$ and $R_f$, derived from (1) | |
|---|---|---|---|---|
| $0 < R_f \le 1/3$ | $R_i - 1$ | $R_i + 1$ | $P_1/P_2 = (1-R_f)/(1+R_f)$ | (range: 1/2 to 1) |
| $1/3 \le R_f \le 2/3$ | $R_i$ | $R_i + 1$ | $P_1/P_2 = 1/R_f - 1$ | (range: 1/2 to 2) |
| $2/3 \le R_f < 1$ | $R_i$ | $R_i + 2$ | $P_1/P_2 = 2/R_f - 1$ | (range: 1 to 2) |

It has to be noted that if $R_f = 0$, making $R$ an integer, the filter can still be used as a classic CIC filter by activating only one comb branch.

Choosing $R_1$ and $R_2$ according to Table 1 makes so that both periods $P_1$ and $P_2$ do not differ from one another by more than a factor 2. Doing otherwise would unbalance the system which would increase the jitter. The right column of the table gives the relation between $P_1/P_2$ and $R_f$. The exact choice of $P_1$ and $P_2$ depends on a trade-off that must be made between precision on $R$ and jitter.

More generally, $R_1$ and $R_2$ are advantageously chosen such that the absolute value of the difference between

$R$ and the mean of $R_1$ and $R_2$ is not higher than 1/3 and $P_1$ and $P_2$ are chosen such that they do not differ from one another by more than a factor 2.

Since the method implemented by the filter consists in switching between two close signals resulting from decimation by integer factors, it introduces time-jitter.

Ideally, the signal should be resampled at instants spaced by a period $RTs$, where $Ts = 1/Fs$ is the high-sampling-rate period. It is actually sampled $P_1$ times at instants separated by $R_1 Ts$ when comb branch 16A is used, and $P_2$ times at instants separated by $R_2 Ts$ when comb branch 16B is used, as shown in figure 2.

If $T = RTs$ is the ideal new sampling period, the maximum time-offset $\delta t$ relative to $T$ is then :

$$\left|\frac{\delta t}{T}\right| = \max\left\{P_1\left|1-\frac{R_1}{R}\right|, P_2\left|1-\frac{R_2}{R}\right|\right\} = \max\left\{\frac{4}{3}\frac{P_1}{R}, \frac{4}{3}\frac{P_2}{R}\right\} \tag{3}$$

according to the values in Table 1.

This relation is used to determine the order of magnitude for $P_1$ and $P_2$ to obtain a good precision while maintaining jitter as low as possible.

For example, with $R = 153.43$, the set $R_1 = 153$, $P_1 = 13$, $R_2 = 154$, $P_2 = 10$ gives an actual decimation factor of 153.435 and a maximal time-offset of 3.7%.

The compensation gains $G_1$ and $G_2$ applied by the amplificator 27 are set to compensate the CIC gains.

The signals issued by the combs 1 and 2 are affected by different gains, namely $(MR_i)^N$ where $R_i$ is the decimation factor of the comb branch $i$, $N$ is the number of differentiators and $M$ is the differential delay of the CIC filter.

Therefore, the samples are multiplied by compensation gains $G_1$ and $G_2$ after having been combined in a single output signal, these gains being defined as below :

$$G_1 = 1/(MR_1)^N \tag{4}$$

$$G_2 = 1/(MR_2)^N \tag{5}$$

The driving unit 28 is adapted to drive the amplificator 27 so that the applied gain is $G_1$ when the samples are outputted by comb 1 and $G_2$ when the samples are outputted by comb 2.

According to an alternative embodiment, the amplifier 27 is adapted for multiplying the samples by a gain $G_1/G_2$ when the samples are outputted by comb 1 and for not multiplying the samples by a gain, when the samples are outputted by comb 2.

In the filter according to the invention, due to the switching from one comb branch to the other, phase continuity is advantageously insured by starting the decimators or samplers 18A, 18B at appropriate times and long enough before switching for yielding latency and pipeline issues.

Thus, according to the invention, the driving unit 28 is adapted to calculate an offset and to start the next comb's decimator at an instant which precedes the switching time by the calculated offset. This offset is denoted $T_1$ for comb 1 and $T_2$ for comb 2. They are expressed in number of input samples for comb 1 and comb 2.

Offsets $T_1$ and $T_2$ have first to deal with signal discontinuities when switching from one comb branch to the other.

The two comb branches have slightly different responses. When switching from one to the other, the composite signal must advantageously remain as continuous as possible.

If $y(k) = y_1(k)$ and $y(k+1) = y_2(k+1)$, with $y(m)$, $y_1(m)$ and $y_2(m)$ being respectively the $m^{th}$ sample at the output of the filter, at the output of comb 1 and at the output of comb 2, it should be made so that $y_2(k)$, the sample that would have been issued by comb 2 at the instant $k$, be as close to $y_1(k)$ as possible.

As known per se, the overall frequency response of a CIC filter relative to the highest rate $Fs$ is given by the following equation :

$$H(f) = \left( \frac{\sin\left(\pi MRf\right)}{\sin\left(\pi f\right)} \right)^{N} e^{-j\pi(MR-1)Nf} \tag{6}$$

with $0 \leq f \leq 1$, 1 corresponding to $Fs$. Nulls appear at multiples of $Fs/MR$, which prevents aliasing in the useful band after decimation. The maximal gain of the filter is obtained for $f = 0$. This value is retained as the filter's gain in the useful band.

According to equation (6), the signals delivered by the 2 comb branches are affected by different phases, the difference being $2\pi \, \Delta f$, with:

$$\Delta = \frac{MN}{2} \, (R_2 - R_1) \tag{7}$$

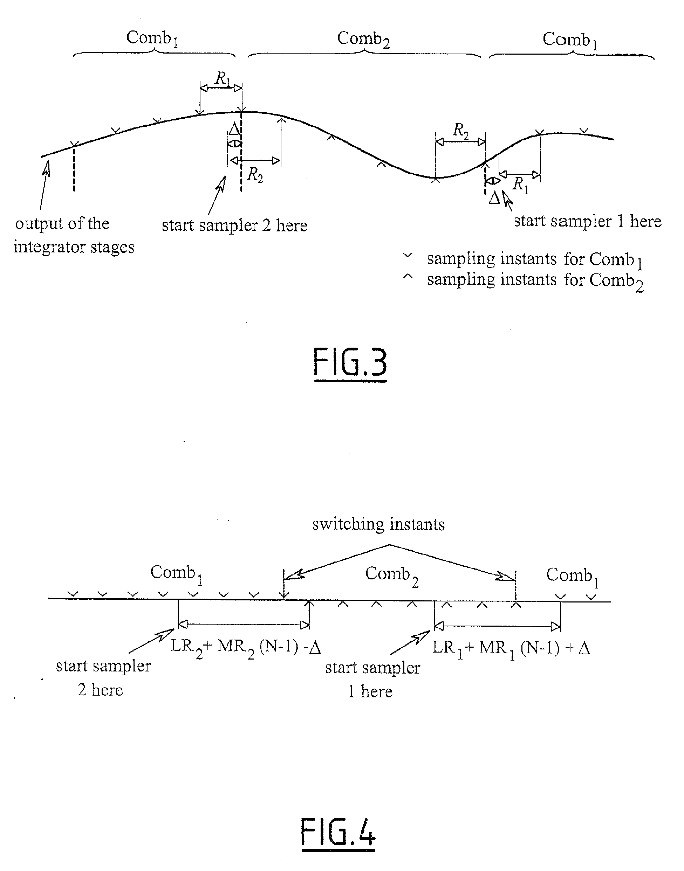

This phase difference is compensated for when switching from one comb to the other by starting the next comb's decimator with a slight offset as compared to the current comb's one, as shown in figure 3.

In this example $R_1 < R_2$ and thus the decimator of comb 2 must be started $\Delta$ samples before in regards to the one of comb 1, and the decimator of comb 1 must be started $\Delta$ after in regards to the one of comb 2.

If $\Delta$ is an integer, the phase can be compensated perfectly. This is always the case if either $M$ or $N$ is even. If both $M$ and $N$ are odd, $\Delta$ may not always be an integer, in which case the phase difference cannot be completely compensated.

As for the amplitude difference, it is not necessary to compensate for it, since its influence on the signal's continuity can be neglected if $R$ is great enough. For example, if the useful bandwidth $B$ equals $1/8 \times Fs/R$ as is often the case, if $R=100$, $R_1=100$, $R_2=101$, $M=1$ and $N=4$, the amplitude ratio derived from equation (6) does not exceed 0.33 dB in the useful band.

Each comb implies latency and pipeline issues.

As known per se, the system function of a CIC filter with $N$ cascaded integrators and differentiators and differential delay $M$ is :

$$H(z) = \frac{\left(1 - z^{-MR}\right)^{N}}{\left(1 - z^{-1}\right)^{N}} = \left( \sum_{k=0}^{MR-1} z^{-k} \right)^{N} \tag{8}$$

According to (8), each filter has a latency of $(MR_i-1)N$, (i = 1 or 2) depending on the comb which is used. This means that, for a relevant sample to be delivered by one of the combs at a given instant, its decimator must be started at least $MR_i(N-1)Ts$ before as long as N < $MR_i$, which is the case in most targeted applications. If N $\geq MR_i$ however, the decimator must be started even sooner.

In practice, the comb stages are pipelined in order to obtain the best performances in terms of throughput, and thus, processed bandwidth. Typically, a one-sample delay would be added after each stage. This introduces an overall delay $LR_i$($L$ samples relative to the comb's output rate).

This delay due to the pipeline is added to the filter's latency to yield the overall delay that must be considered.

These two parameters as well as $\Delta$, the time offset that is introduced to insure phase continuity of the signal, are used by the driving unit 28 to determine the instant when to start the next comb's decimator before switching, as shown in figure 4 :

$LR_1 + MR_1(N\text{-}1)+\Delta$ input samples before switching time for comb 1.

$LR_2 + MR_2(N\text{-}1)\text{-}\Delta$ input samples before switching time for comb 2.

These two latencies give a lower bound for the periods $P_1$ and $P_2$.

The invention uses a decimation CIC filter with 2 comb branches that run at slightly different rates. By switching from one comb to the other, it is possible to reconstruct a signal decimated by a rational factor instead of being limited to an integer factor as is the case with classic CIC filters. The method is easily implemented with a minimum additional control logic. Some rules must be followed in order to obtain a signal with good quality: compute proper values for the two integer decimation factors and the periods during which they are applied, compensate for the gain difference, insure phase continuity upon switching by starting the decimators at the appropriate time, and start them long enough before to account for various latencies.

The claimed process can be implemented by a calculator using an adapted computer software.

Advantageously, the process is implemented on a hardware component which does not use any software like an ASIC or a FPGA.

**Claims**

1. Decimation filter for decimation of a digital signal by a rational decimation factor (R) including :

   - a cascade of integrators (12),
   - at least a comb branch (16A, 16B) including

      - a decimator (18A, 18B),
      - a cascade of differentiators (22A, 22B),

   **characterized in that** it includes :

   - a first and a second comb branches (16A, 16B) both adapted to receive the samples from said cascade of integrators (12), the decimators (18A, 18B) of the first and second comb branches having a first and a second integer decimation factors ($R_1$, $R_2$) which are different,
   - switching means (26, 28) for delivering at the output of the filter successively a first set of consecutive samples ($P_1$) outputted by the first comb branch (16A) and a second set of consecutive samples ($P_2$) outputted by the second comb branch (16B).

2. Decimation filter according to claim 1, **characterized in that** the first and second integer decimation factors ($R_1$, $R_2$) are such that the absolute value of the difference between the rational decimation factor (R) and the mean of the first and second decimation factors ($R_1$, $R_2$) is not greater than 1/3.

3. Decimation filter according to any one of claims 1 and 2, **characterized in that** the number of samples ($P_1$) of the first set of samples outputted by the first comb branch (16A) and the number of samples ($P_2$) of the second set of samples outputted by the second comb branch (16B) do not differ from one another by more than a factor 2.

4. Decimation filter according to claims 2 and 3, **characterized in that** the first and second integer decimation factors $R_1$, $R_2$, the number $P_1$ and $P_2$ of samples of the first and second sets of samples outputted respectively by the first and the second comb branches (16A, 16B) comply with the following table :

| $R_f$ | $R_1$ | $R_2$ | relation between $P_1/P_2$ and $R_f$, derived from (1) | |
|---|---|---|---|---|
| $0 < R_f \leq 1/3$ | $R_i - 1$ | $R_i + 1$ | $P_1/P_2 = (1-R_f)/(1+R_f)$ | (range: 1/2 to 1) |
| $1/3 \leq R_f \leq 2/3$ | $R_i$ | $R_i + 1$ | $P_1/P_2 = 1/R_f - 1$ | (range: 1/2 to 2) |
| $2/3 \leq R_f < 1$ | $R_i$ | $R_i + 2$ | $P_1/P_2 = 2/R_f - 1$ | (range: 1 to 2) |
| $R_i$ being the integer part of the rational decimation factor $R$ ; and | | | | |
| $R_f$ being the fractional part of the rational decimation factor $R$. | | | | |

5. Decimation filter according to any one of the preceding claims, **characterized in that** it includes an amplifier (27) adapted to apply a first and a second compensation gains ($G_1$, $G_2$) to the samples outputted by the first and second comb branches (16A, 16B) respectively.

6. Decimation filter according to claim 5, **characterized in that** the first and second gains $G_i$ with i = 1 and i = 2 are given by

$$G_i = 1/(MR_i)^N$$

where

$R_i$ is the integer decimation factor of the comb branch $i$
$N$ is the number of differentiators in the comb branch $i$
$M$ is the differential delay of the CIC filter

7.  Decimation filter according to any one of the preceding claims, **characterized in that** the switching means (26, 28) include a driving unit (28) adapted to start the decimator (18A, 18B) of the inactive comb branch an offset of time, before the switching instant in order for it to deliver relevant samples.

8.  Decimation filter according to claim 7, **characterized in that** said offset is set for compensating the phase discontinuities between the first and the second comb branches.

9.  Decimation filter according to claim 7, **characterized in that** the offset is dependent on $MN(R_2 - R_1)/2$
    where
    $R_i$ is the integer decimation factor of the comb branch $i$
    $N$ is the number of differentiators in the comb branch $i$
    $M$ is the differential delay of the CIC filter.

10. Decimation filter according to any one of claims 7 to 9, **characterized in that** said offset is calculated for compensating latency.

11. Decimation filter according to claim 10, **characterized in that** the offset is dependent on $MR_i(N - 1)$
    where
    $M$ is the differential delay of the CIC filter,
    $R_i$ is the integer decimation factor of the comb branch $i$,
    $N$ is the number of differentiators in the comb branch $i$.

12. Decimation filter according to any one of claims 7 to 11, **characterized in that** said offset is calculated for compensating the pipeline effect.

13. Decimation filter according to claim 12, **characterized in that** the offset is dependent on $LR_i$
    where $L$ is the number of pipeline stages of each comb branch,
    $R_i$ is the integer decimation factor of the comb branch $i$.

14. Process for decimation of a digital signal by a rational decimation factor (R) including the steps of:

    -   integrating the digital signal,
    -   in at least a comb branch (16A, 16B):

        -   decimating the integrated digital signal,
        -   differentiating the decimated integrated digital signal,

    **characterized in that** it includes the step of :

    -   in a first comb branch (16A), decimating the samples of the integrated digital signal by a first integer decimation factor ($R_1$),
    -   in a second comb branch (16B), decimating the samples of the integrated digital signal by a second integer decimation factor ($R_2$), the first and second integer decimation factors ($R_1$, $R_2$) being different,
    -   delivering successively a first set of consecutive samples ($P_1$) outputted by the first comb branch (16A) and a second set of consecutive samples ($P_2$) outputted by the second comb branch (16B).

15. Computer program for a decimation filter, comprising a set of instructions, which, when loaded into a calculator, causes the calculator to carry out the method of claim 14.

## FIG.1

## FIG.2

Comb₁     Comb₂     Comb₁

$R_1$

$\Delta$

$R_2$

output of the
integrator stages

start sampler 2 here

$R_2$

$R_1$

$\Delta$

start sampler 1 here

∨   sampling instants for Comb₁
∧   sampling instants for Comb₂

## FIG.3

switching instants

Comb₁     Comb₂     Comb₁

$LR_2 + MR_2\,(N\text{-}1)\,\text{-}\Delta$      $LR_1 + MR_1\,(N\text{-}1)\,\text{+}\Delta$

start sampler
2 here

start sampler
1 here

## FIG.4

**European Patent Office**

# EUROPEAN SEARCH REPORT

Application Number

EP 03 29 2099

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 163 787 A (MENKHOFF ANDREAS) 19 December 2000 (2000-12-19) * figure 3 * * column 2, line 62 - column 4, line 5 * * column 5, line 19 - column 6, line 63 * * column 7, line 57 - line 64 * --- | 1-15 | H03H17/06 |
| A | US 4 999 798 A (MCCASLIN SHAWN R ET AL) 12 March 1991 (1991-03-12) * column 3, line 4 - column 6, line 23 * * figure 2 * --- | 1,14 | |
| A | DE 199 19 575 C (SIEMENS AG) 11 January 2001 (2001-01-11) * column 3, line 47 - column 5, line 26 * * figure 2 * --- | 1,14 | |
| A | BABIC D ET AL: "DECIMATION BY IRRATIONAL FACTOR USING CIC FILTER AND LINEAR INTERPOLATION" 2001 IEEE INTERNATIONAL CONFERENCE ON ACOUSTICS, SPEECH, AND SIGNAL PROCESSING. PROCEEDINGS. (ICASSP). SALT LAKE CITY, UT, MAY 7 - 11, 2001, IEEE INTERNATIONAL CONFERENCE ON ACOUSTICS, SPEECH, AND SIGNAL PROCESSING (ICASSP), NEW YORK, NY: IEEE, US, vol. 6 OF 6, 2001, pages 3677-3680, XP001184122 ISBN: 0-7803-7041-4 ----- | | TECHNICAL FIELDS SEARCHED (Int.Cl.7) H03H |

The present search report has been drawn up for all claims

| Place of search | Date of completion of the search | Examiner |
|---|---|---|
| THE HAGUE | 30 January 2004 | Lecoutre, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 03 29 2099

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2004

| Patent document cited in search report | | Publication date | Patent family member(s) | | Publication date |
|---|---|---|---|---|---|
| US 6163787 | A | 19-12-2000 | EP | 0889587 A1 | 07-01-1999 |
| | | | JP | 11122080 A | 30-04-1999 |
| US 4999798 | A | 12-03-1991 | NONE | | |
| DE 19919575 | C | 11-01-2001 | DE | 19919575 C1 | 11-01-2001 |
| | | | WO | 0067375 A1 | 09-11-2000 |

EPO FORM P0459

For more details about this annex : see Official Journal of the European Patent Office, No. 12/82